(19) Europäisches Patentamt
European Patent Office
Office européen des brevets

(11) **EP 4 600 670 A1**

(12) **EUROPEAN PATENT APPLICATION**

(43) Date of publication:
**13.08.2025 Bulletin 2025/33**

(21) Application number: **24305231.3**

(22) Date of filing: **12.02.2024**

(51) International Patent Classification (IPC):
*G01R 31/26* (2020.01)          *G01R 31/28* (2006.01)

(52) Cooperative Patent Classification (CPC):
**G01R 31/2621; G01R 31/2608; G01R 31/2642;**
G01R 31/2817

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicants:
• **Mitsubishi Electric R&D Centre Europe B.V.**
**1119 NS  Schiphol Rijk Amsterdam (NL)**
Designated Contracting States:
**FR**
• **MITSUBISHI ELECTRIC CORPORATION**
**Chiyoda-ku**
**Tokyo 100-8310 (JP)**
Designated Contracting States:
**AL AT BE BG CH CY CZ DE DK EE ES FI GB GR HR HU IE IS IT LI LT LU LV MC ME MK MT NL NO PL PT RO RS SE SI SK SM TR**

(72) Inventors:
• **Quemener, Vincent**
**35708 RENNES CEDEX 7 (FR)**
• **DEGRENNE, Nicolas**
**35708 RENNES CEDEX 7 (FR)**

(74) Representative: **Plasseraud IP**
**104 Rue de Richelieu**
**CS92104**
**75080 Paris Cedex 02 (FR)**

(54) **AN ELECTRONIC CIRCUIT ARRANGEMENT AND METHOD TO DETERMINE DEGRADATION OF VOLTAGE-CONTROLLED POWER TRANSISTOR, CORRESPONDING DEVICE AND COMPUTER PROGRAM**

(57)    The disclosure relates to an electronic circuit arrangement comprising at least one voltage-controlled power transistor (VCPT, MOSFET, IGBT), the electronic circuit arrangement comprising a degradation measurement module (DMM) for monitoring the degradation of the at least one voltage-controlled power transistor (VCPT), the degradation measurement module comprising a current injection module (CIM) which is connected to the emitter of the at least one voltage-controlled power transistor (VCPT), and a degradation measurement module (DMM), the degradation measurement module being able to measure a first voltage ($V_{eg}$) following a current injection (Iinj) at the emitter of the at least one voltage-controlled power transistor (VCPT), the current injection module (CIM) and the degradation measurement module (DMM) being connected to the same ground.

Fig. 1

EP 4 600 670 A1

**Description**

1. Domain

The disclosure relates to the determination of fatigue, like pre-failure condition, for voltage-controlled power transistor. The disclosure finds utility in predictive maintenance with respect to sustainability, for which the replacement of all or part of the electronic components included in a device should occur at the best possible time before the failure occur.
The disclosure finds an application in electric power device (e.g. inverters, transformer) and any power electronics applications where high voltage and/or high current switching are required.

2. Prior Art

In the context of electric power applications, the term "power modules" typically refers to integrated semiconductor devices that combine multiple power components in a compact and modular package. These modules are designed for high-power applications and are commonly used in power electronic systems for tasks such as voltage conversion, current regulation, and power amplification. Power modules are crucial in various industries, including renewable energy systems, electric vehicles, industrial motor drives, and uninterruptible power supplies.
A power module often includes one or more power semiconductor devices, such as insulated gate bipolar transistors (IGBTs), metal-oxide-semiconductor field-effect transistors (MOSFETs), or diodes, along with associated control circuitry, thermal management features, and sometimes passive components like capacitors or resistors. The integration of these components into a single module offers several advantages, including improved reliability, ease of installation, reduced assembly complexity, and enhanced thermal performance.
As a reminder, A MOSFET, or Metal-Oxide-Semiconductor Field-Effect Transistor, is a type of transistor used in electronic devices. It has three main terminals: Gate (G), Source (S), and Drain (D). Here's a brief explanation of each terminal and its function:

- Gate (G): The gate is the terminal that controls the flow of current between the source and drain. By applying a voltage to the gate terminal, an electric field is created in the semiconductor material beneath the gate. This electric field controls the conductivity of the channel between the source and drain. When a voltage is applied to the gate, it either allows or blocks the flow of current between the source and drain, depending on the type of MOSFET (N-type or P-type).
- Source (S): The source is the terminal from which the current flows into the channel of the MOSFET. In an N-type MOSFET, the source is typically connected to the negative terminal of the power supply, while in a P-type MOSFET, it's connected to the positive terminal. The source provides the carriers (electrons or holes) that form the current flowing through the channel.
- Drain (D): The drain is the terminal through which the current exits the MOSFET. It's the output terminal. The current flows through the source and drain in both directions, and this flow is controlled by the voltage applied to the gate.

Always as a reminder, An IGBT, or Insulated Gate Bipolar Transistor, is a type of power semiconductor device that combines features of both MOSFETs and bipolar junction transistors (BJTs). Like MOSFETs, IGBTs have three main terminals: Gate (G), Emitter (E), and Collector (C). Here's a brief explanation of each terminal and its function:

- Gate (G): The gate terminal in an IGBT plays a role similar to that in a MOSFET. It is used to control the current flow between the other two terminals, the emitter and collector. Applying a voltage to the gate allows or prevents the flow of current between the emitter and collector. The gate voltage controls the conductivity of the IGBT, making it function as a switch.
- Emitter (E): The emitter is the terminal from which the majority carriers (either electrons or holes) are injected into the device. In an IGBT, the emitter is typically associated with the N-type material. It provides the carriers that flow through the channel and into the collector terminal.
- Collector (C): The collector is the terminal through which the current exits the IGBT. It's the output terminal. The current flows from the collector to the emitter, and this flow is controlled by the voltage applied to the gate.

Thus, the MOSFET and the IGBT act as a voltage-controlled switch. The voltage applied to the gate controls the current flow between the source and drain or the collector and the emitter. When a specific voltage is applied to the gate, the MOSFET and the IGBT allow current to flow (it's in the "on" state), and when a different voltage is applied, it blocks the current flow (it's in the "off" state). This property makes MOSFET and the IGBT fundamental components in electronic circuits, used for amplification, switching, and signal processing. In essence, however, the IGBT combines the voltage control of a MOSFET with the current-carrying capability of a BJT. It is commonly used in power electronics applications where high voltage and high current switching are required. The IGBT is often employed in motor drives, power inverters, and other applications where efficient and controlled switching of electrical power is crucial.

A problem with these two types of components lays on the lifetime one may consider some deficiencies are to appear. For example, lifetime (mathematical) models of high-power Insulated Gate Bipolar Transistors modules express the number of cycles to end of life as a function of stress parameters. These models are normally developed based on experimental data from accelerated power-cycling tests performed at predefined temperature stress conditions as, for example, with temperature swings above 60 °C. However, in real power converters applications, the power modules are usually stressed at other temperature cycles (either more or less than above 60 °C). Thus, extrapolating the parameters of lifetime models developed using data from these temperature stress cycles experiments might result in erroneous lifetime estimations.

In addition, in a context of predictive maintenance and sustainability, it is no more desirable to change some components or entire circuit of components to prevent failures.

In this perspective, on knows that power components lifetime is limited by the junction temperature swing during mission profile and wire bonds failure is one of the limiting factors for the reliability. Classical wear out mechanisms are created by the combination of thermal cycling and coefficient of thermal expansion (CTE) mismatches leading to mechanical stresses between the wires bond and the die metallization inside the components. These cause cracks to propagate from the periphery to the centre of the bonds. Monitoring the degradation of the wire bonds is required for protection or condition-based die shedding. On-line monitoring is required in application for which the mission profile is not known.

Most prior-art methods perform the estimation of wire bond lift-off by measuring the steady state voltage through high current (e.g., Vce in IGBT or Vds in MOSFET). The main issue using this technique that it is current and temperature dependent. It thus requires a complex calibration procedure to compensate for these factors. Moreover, this technique requires a connection to the high (drain or collector) voltage which imposes high design and safety constraints. The clamp circuit that must be implemented to protect the measure imposes time-responses incompatible with fast switching frequencies. This makes this technique quite incompatible for commercial application.

Another method is by measuring the voltage change between a kelvin probe and the power emitter (VeE) during the conduction time. It reduces the temperature dependencies and the clamp requirements, but a 'true' Kelvin emitter is required, which is not always available in high current power modules.

Another prior-art method is by measuring the voltage change between the kelvin probe and the power emitter (VeE) during the switching time dV/dt. However, this technique based on monitoring the transient switching waveforms remains expensive, inaccurate, and non-robust due to the high frequency sensor requirements, the low sensitivity and the complex dependencies with operating conditions and implementations.

In consequence, the disclosure aims at improving the situation.

3. Summary

The disclosure relates to a circuit arrangement and a method for monitoring the degradation status of voltage-controlled power transistors.

More specifically, according to a first aspect the disclosure relates to an electronic circuit arrangement comprising at least one voltage-controlled power transistor, the electronic circuit arrangement comprising a degradation measurement module for monitoring the degradation of the at least one voltage-controlled power transistor, the degradation measurement module comprising a current injection module which is connected to the emitter of the at least one voltage-controlled power transistor, and a degradation measurement module, the degradation measurement module being able to measure a first voltage following a current injection at the emitter of the at least one voltage-controlled power transistor, the current injection module and the degradation measurement module being connected to the same ground.

Thus, the arrangement allows monitoring the degradation of the voltage-controlled power transistor(s) during its(their) lifetime, with minimal changes to its functioning, and to the power circuit and device.

According to a feature, the electronic circuit arrangement further comprises at least one switch, the switch having an open state and a closed state, the closed state being switchable to the open state for allowing the degradation measurement module to measure the voltage following the current injection at the current injection module.

Thus, the arrangement allows selectively monitoring the degradation of the voltage-controlled power transistor(s) while also allowing normal operations.

According to a feature, the electronic circuit arrangement is linked to a driver of the at least one voltage-controlled power transistor, the driver being connected to the gate of the at least one voltage-controlled power transistor and the ground of the driver being the same that the one of the current injection module and of the degradation measurement module.

Thus, the potential of the various components of the circuit is common, allowing a seamless implementation of the degradation monitoring.

According to a feature, the at least one voltage-controlled power transistor comprises a Kelvin Emitter and wherein the electronic circuit arrangement comprises at least two additional switches allowing the degradation measurement module to measure the first voltage and allowing the degradation measurement module to measure a second voltage following a current injection at the Kelvin Emitter.

According to a feature, the degradation measurement module comprises an analog-to-digital converter.

According to a feature, the degradation measurement module comprises:

- a current mirror component to copy the current injection of the current injection module in two distinct current flow,
- the first current flow being injected into the Kelvin Emitter of the at least one voltage-controlled power transistor for measuring a first voltage,
- the second current flow being injected into a subcircuit comprising a threshold resistance for measuring a threshold voltage,
- a comparator, the inputs of which receiving the first voltage and the threshold voltage, the comparator delivering a degradation signal.

According to a second aspect, the disclosure relates to a method for monitoring the degradation of at least one voltage-controlled power transistor, the method using an electronic circuit arrangement as disclosed, the method at least one iteration of:

- checking whether at least one predetermined condition for degradation monitoring of the at least one voltage-controlled power transistor is met,
- when it is determined that the at least one condition is met:

  - injecting a direct current DC, using the CIM, at the power emitter of the at least one voltage-controlled power transistor,
  - measuring, using the RMM, at least one voltage response.

According to a feature, the at least on predetermined condition for degradation monitoring of the at least one belongs to the group comprising: a temperature the at least one voltage-controlled power transistor, a specific state of the at least one voltage-controlled power transistor.

According to a feature, the method further comprises, with the at least one voltage response, obtaining at least one internal resistance of the at least one voltage-controlled power transistor.

According to a feature, the method further comprises determining that the at least one internal resistance of the at least one voltage-controlled power transistor exceeds a predetermined value and transmitting an alarm signal to a monitoring device.

According to a third aspect, the disclosure relates to a computer program comprising instructions causing the implementation of the method according to anyone of the preceding claims when such instructions are run by a processor. This computer program may be stored in a component of a monitoring board of an electronic power device, and/or shared between devices of a system for monitoring voltage-controlled power transistors of the electronic power device.

According to a fourth aspect, the disclosure relates to a device for monitoring the degradation of at least one voltage-controlled power transistor implanted on a power electronic circuit, the system comprising at least one electronic circuit arrangement as disclosed and at least one driver for driving the current flow in said of at least one voltage-controlled power transistor, the system further comprising a monitoring module for receiving data representing the degradation of at least one voltage-controlled power transistor from the at least one electronic circuit arrangement.

4. Drawings

More details are presented in the specification below, with reference to the appended drawings where:

- Figure 1, illustrates a circuit arrangement for the measurement of the Rg-total with a current injection and a degradation measurement module,
- Figure 2 illustrates an equivalent model of the gate-emitter circuit in a power transistor including the different wire bonds,
- Figure 3 shows an example of mission profile of the transistor including a standby mode where Rg can be monitored at the temperature $T_m$,
- Figure 4 illustrates an equivalent model of the gate-emitter circuit in a power transistor with a kelvin emitter and Power emitter,
- Figure 5, shows an example of a circuit arrangement to alternately measure Veg and VEg and the diagram of measurement,

- Figure 6 shows an example of a second circuit arrangement to alternately measure Veg and VEg,
- Figure 7 illustrates a sequence of measurement to alternately measure the wire bonds degradation (during OFF-state) and the load current (during ON-state),
- Figure 8, shows an equivalent model of the gate-emitter circuit in a power transistor with a false kelvin emitter and Power emitter,
- Figure 9 illustrates a circuit to measure the wire bond degradation using a comparator with a threshold resistance $R_{emu}$,
- Figure 10 illustrates, for the circuit arrangement of figure 9, exemplary waveforms during 3 pulses for different state of wire bond degradation 1) at initial state 2) at maximum state and 3) at state higher than the degradation threshold,
- Figure 11 illustrates an example of device for implementing the method according to the disclosure.

### 5. Description of embodiments

#### 5.1. General disclosure

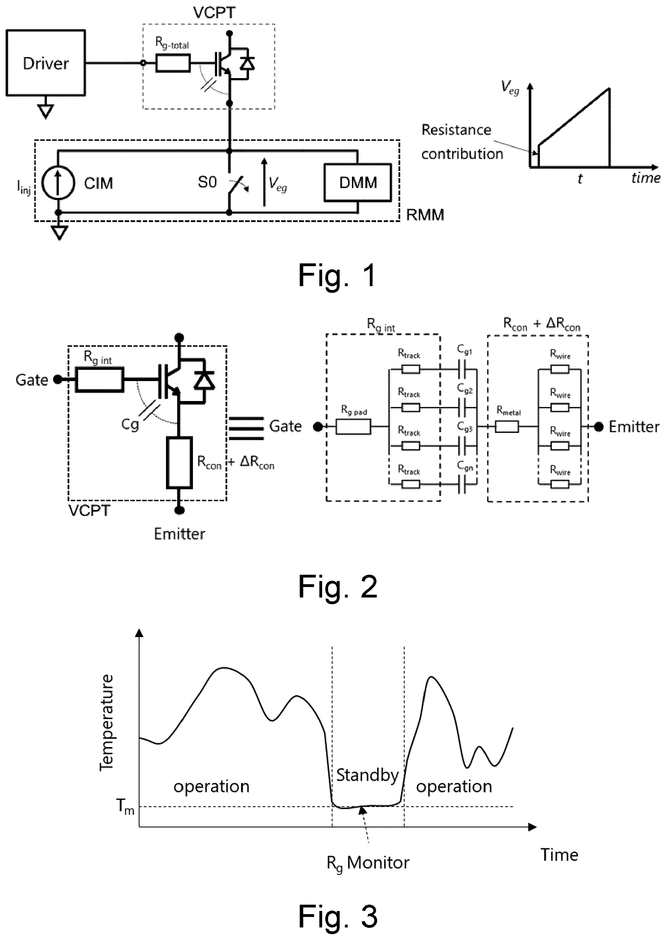

The disclosure relates to a circuit arrangement and method (for using the circuit arrangement) which allows to measure the total resistance in the emitter-to-gate loop ($R_{g\text{-}total}$) evolution during the operation of a device using an injection of DC current through the emitter path. The measurement is done by injecting a DC current through the emitter to gate path in the on-state or off-state of the PWM allowing to measure $R_{g\text{-}total}$, as shown in figure 1.

The inventors demonstrated that the total gate resistance $R_{g\text{-}total}$ is composed of several resistors in series and parallel which include the resistances of electrical interconnections. Thanks to the method of the disclosure, the evolution of the resistance is monitored during the operation of the device to provide an indication of the degradation of the electrical interconnections within the transistor to prevent failures and plan maintenances.

According to the disclosure, attention is paid on the degradation-dependent resistances in the emitter-to-gate loop rather than on the temperature-dependent internal gate resistance. This way of monitoring the internal resistance has proven to be simple and efficient to determine the fatigue of the component and to plan preventive maintenance.

The problem addressed by the disclosure is thus to monitor the wire-bond degradation accurately, in a cost-effective way, and with a simple calibration procedure.

In a general embodiment, the circuit arrangement comprises a degradation measure module (RMM on the figures), as exposed in figure 1, which is connected to the Emitter (Source) of the voltage-controlled power transistor (on the figures, the voltage-controlled power transistor is denoted VCPT), and which is able to measure the internal resistance of this transistor. More specifically, the degradation measure module RMM comprises one current injection (Iinj) module (CIM), a switch (S0) (placed in parallel to the current injection (Iinj) module (CIM) which allows measuring the voltage (Veg) thru a degradation measurement module DMM (e.g., may an analogic to digital converter (ADC), a resistance coupled with a logic gate, etc.). The ground of the current injection (Iinj) module CIM and the degradation measurement module DMM are identical. This ground can be the same that the one of the Driver. The driver circuit depend on the application and the requirement of the power electronic system. For example, it can be composed of a two MOSFET in totem-pole configuration by a driver signal (e.g 3.3V) to switch the VCPT with two voltages (e.g. +20V/5V) . The current injection (Iinj) module CIM and the degradation measurement module RMM are both connected to the Emitter (Source) of the voltage-controlled power transistor VCPT. In some configuration, the degradation measure module may also comprise the necessary circuitry for using a Kelvin probe (when such probe is integrated in the voltage-controlled power transistor). Examples of such configuration are described below. As a function of implementation constraints, the current injection module CIM may be a dedicated current injection module, which is used for the sole purpose of monitoring the degradation of component(s). But the current injection module CIM may use an existing circuitry already connected to the emitter of the VCPT. As a function of the implementation, the degradation measure module RMM may directly be integrated into the driver of the system. For instance, the driver may directly be able to monitor degradation of one or several of the components it pilots so as to inform a monitoring system of the need of replacement of one or several components.

Thanks to this arrangement and the presence of the degradation measure module, it is thus possible to measure, in situ, the evolution of the internal resistance of the voltage-controlled power transistor (which is linked to the internal wire-bond degradation), and to trigger a replacement of the transistor (or the replacement of an entire electronic circuitry) when the internal resistance exceed a predetermined threshold. More specifically, the measurement method comprises several iterations of the following steps:

- Check whether a predetermined condition for degradation monitoring of the VCPT (e.g., a specific temperature to be met, and/or a specific state of the VCPT, and/or other conditions);
- When it is determined that such condition(s) is(are) met:

- Inject a direct current DC (of a predetermined intensity, e.g in the range of 10-100mA), using the CIM, at the power emitter of the VCPT, during a time duration (e.g. range of microseconds) to have only a small variation of the gate voltage and not modify the state of the VCPT
- Measure, using the RMM, a voltage response ($V_{eg}$). The degradation estimation (DEst) is deduced from this voltage response by calculating a resistance, according to ohm's law.

The injection and measure are not time consuming and are usually made in ranges of microseconds. The calculated resistance is logged, along with the date/time of the measure (and optionally with an identifier of the VCPT), in a logging module and the evolution of the resistance is tracked until a predetermined value is reached, which may trigger the emission of an alarm signal to a monitoring tool, the alarm signal comprising for example the identification of the VCPT (or the identification of the electronic circuit (also called module by the one skilled in the art) in which the VCPT is about to fail).

In addition, the circuit arrangement of the disclosure is not limited to adding a degradation measurement module RMM to one voltage-controlled power transistor. More specifically, according to an aspect of the disclosure, the arrangement made is optimized in order to limit cost increasing. For example, in the case of an electronic circuit comprising several voltage-controlled power transistors (like an inverter for example), one single degradation measurement module is connected to part of all of the voltage-controlled power transistors, with additional switches that allows selecting, before the measurement, which one of the voltage-controlled power transistors the measure is to be done for. Hence, the additional cost of adding the degradation measurement module is limited (at least shared by several voltage-controlled power transistors) and a degradation monitoring method is used to selectively measure, at predetermined time intervals, the internal resistance of these voltage-controlled power transistors. The values are then logged, and a signal is transmitted to a degradation monitoring module (which can be implemented in a global monitoring software for example) to inform of a pre-failure of the component.

With respect to the disclosure, it is understood that the degradation measurement module may comprise some computational capabilities, adapted for, for example determine a voltage difference and/or an internal difference between a predetermined value and an actual value. In addition, according to the disclosure, degradation measurement module may also be a simple measure and transmit module, with limited or computational capabilities, the transmission of the measured value (e.g., voltages) being done thru a track of printed circuit to an additional component, like e.g. a monitoring module, which is in charge of computing the degradation values, to identify the VCPT and to log data.

In the paragraphs below, several situations are presented in which the circuit arrangement of the disclosure is used and implemented (in several different ways) to determine the internal resistance of the power transistor(s) to which the circuit is connected. The internal resistance is also called degradation in some situations. Since the internal resistance mainly depends on the measured voltage, the degradation also refers to this measured voltage or difference of voltage, as it will be explained below. In addition, two variations of the degradation measurement module are presented: the use of an ADC or the use of a dedicated resistance and a logic and gate.

### 5.2. Measurement during diagnostic sequence at a predetermined temperature Tm

According to a first situation of the circuit arrangement and method of the disclosure, the internal measurement is done during specific diagnostic sequences, at a known temperature Tm. More specifically, the method uses emitter-to-gate injection of a DC current $I_{inj}$, in the range of the tens of milliampere during a short time below few microseconds, to measure the total resistance $R_{g\text{-}total}$, as described in relation with previously presented Figure 1. The injection can be done during the pulse width modulation, PWM, during the ON-state or the OFF-state. The use of small current and short current injection will not influence the gate voltage of the transistor sufficiently to change its state and it will continue to operate normally.

Actually, the inventors determined that the internal gate resistor can be described by an equivalent model composed of a network of different resistances in series and parallel with gate capacitors, as shown in Figure 2. The resistance, $R_{g\text{-}total}$ is mainly composed of $R_{g\,int}$ composed for example of polysilicon with a main resistance on the gate pad ($R_{g\,pad}$) in series with a network of gate tracks connecting all the parallel transistor gates cells of the power transistor ($R_{track}$). $R_{g\,int}$ is sensitive to the temperature and can be used as TSEP to monitor the temperature of the transistor. The below equation 1 describes $R_{g\text{-}total}$ which is composed of $R_{g\,int}$ which depends on the temperature in series with $R_{con}$ composed of the resistance of the metallization, $R_{metal}$, and wire bonds in parallel, $R_{wire}$. The degradation of $R_{con}$ result in an increase of the resistance $R_{con}$ by a value $\Delta R_{con}$, where $\Delta R_{con} = 0$ at the early life of the transitor.

By fixing the temperature constant at $T_m$ of the transistor and measuring $R_{g\text{-}total}$ continuously, one can monitor the degradation of the metallization and/or wire-bonds (bond degradation and lift-off). The measurement can be done in OFF-state, or ON-state with the load current $I_{load}=0$. The degradation results in an increase of $R_{g\text{-}total}$ which can thus be monitored and gives information of the degradation of the power module. Above a threshold value of $R_{g\text{-}total}$, a predictive maintenance can be conducted before a catastrophic failure of the device.

$$R_{g-total} = R_{g\,int} + R_{con} + \Delta R_{con} = R_{g\,pad}(T) + \frac{1}{\sum_i^n \frac{1}{R_{track}^i(T)}} + R_{metal}$$

$$+ \frac{1}{\sum_i^m \frac{1}{R_{wire}^i}} \tag{1}$$

This technic can be conducted in-situ during a diagnostic stage when the device is in standby mode and the temperature reaches $T_m$. An example of mission profile is shown in figure 3 where the device temperature changes during the mission profile. During the standby stage when the system is not used and the temperature of the system reaches the temperature $T_m$, $R_{g-total}$ can be monitored. The temperature $T_m$ can be measured by any kind of sensors like a thermocouple positioned in the system, or in the electronic circuit or in the circuit arrangement itself. If the standby mode is sufficiently long, one can assume that the transistor and the system have stable and equal temperatures and $R_{g-total}$ can be measured. Another way to measure the temperature of the transistor is by using TSEP.

The steps of the degradation monitoring method are, in this case:

- Detect a condition of pre-defined junction temperature (like reaching Tm during a predetermined amount of time)
- Inject a DC current through the power emitter in OFF-state or in ON-state with $I_{load}$=O,
- Measure a voltage response. The degradation estimation is deductible from this voltage response.

The injection and measure are not time consuming and are usually made in ranges of microseconds.

Advantageously, the degradation of wire bonds can be measured without calibration procedure by comparing the evolution of $R_{g-total}$. If $R_{g-total}$ rises to one defined threshold, a preventive maintenance can be conducted.

In addition, since the monitoring can be performed in-situ in a specific diagnostic mode when the system is in standby mode, no additional monitoring tool is needed. The measurement can be either done in OFF-state, or ON-state (of the transistor) where the load current $I_{load}$=O, which implies that the measurement rate can be adapted to conditions.

Furthermore, this removes any perturbation from the load current. The measurement is not intrusive and cannot disturb the operation of the device. Finally, the short pulse current used by the current injector cannot modify the normal operation of the transistor.

### 5.3. Measurement using true kelvin and power emitter

According to a second situation of the circuit arrangement and method of the disclosure, the internal measurement is done using a "true" kelvin probe which is already present in the transistor.

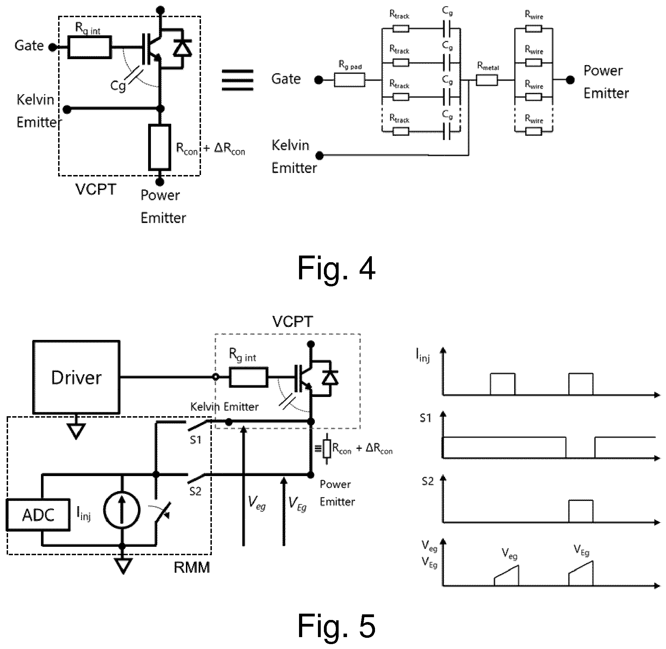

In this situation, the inventors determined that the contribution of wire resistance in $R_{g-total}$ can be monitored using the difference of resistance through kelvin probe ($R_{ge}$) and power probe ($R_{gE}$). The figure 4 shows the equivalent circuit of the transistor including a Kelvin probe emitter. The equation 2 and 3 describe resistance measured with the true kelvin emitter ($R_{ge}$) and measured with the power emitter ($R_{gE}$), respectively.

$$R_{ge} = R_{g\,int} = R_{g\,pad}(T) + \frac{1}{\sum_i^n \frac{1}{R_{track}^i(T)}} \tag{2}$$

$$R_{gE} = R_{g-total} = R_{g\,pad}(T) + \frac{1}{\sum_i^n \frac{1}{R_{track}^i(T)}} + R_{metal} + \frac{1}{\sum_i^m \frac{1}{R_{wire}^i}} \tag{3}$$

Combining eq. 2 and 3, one can measure $\Delta Rg = RgE - Rge$, equation 4. This allows to perform measurement during operation independently to the transistor temperature.

$$\Delta R_g = R_{gE} - R_{ge} = R_{con} + \Delta R_{con} = R_{metal} + \frac{1}{\sum_i^m \frac{1}{R_{wire}^i}} \tag{4}$$

Thus, by alternately injecting the DC current through the kelvin emitter and the power emitter, the degradation of the wire-bond and the metallization can be evaluated during the operation of the transistor. In this situation, the steps of the degradation monitoring method are:

- Inject a DC current through the Kelvin emitter in OFF-state or in ON-state with $I_{load}$=O, and measure a first voltage response $V_{eg}$
- Inject a DC current through the power emitter in OFF-state or in ON-state with $I_{load}$=O, and measure a second voltage response $V_{Eg}$
- Compute a degradation estimation as the subtraction of the two voltage responses.

One possible circuit is shown in figure 5 where two switches (S1, S2) are connected to the kelvin emitter and the power emitter. The sequence of measurement is then made in two steps. In the first step, the current is injected through the kelvin emitter where S1 is ON and S2 is OFF, and $V_{eg}$ is measured. In the second step, the current is injected through the power emitter where S1 is OFF and S2 is ON and $V_{Eg}$ is measured.

Note that the method can be combined with Tj estimation as described in the state-of-the-art method using the first measured voltage.

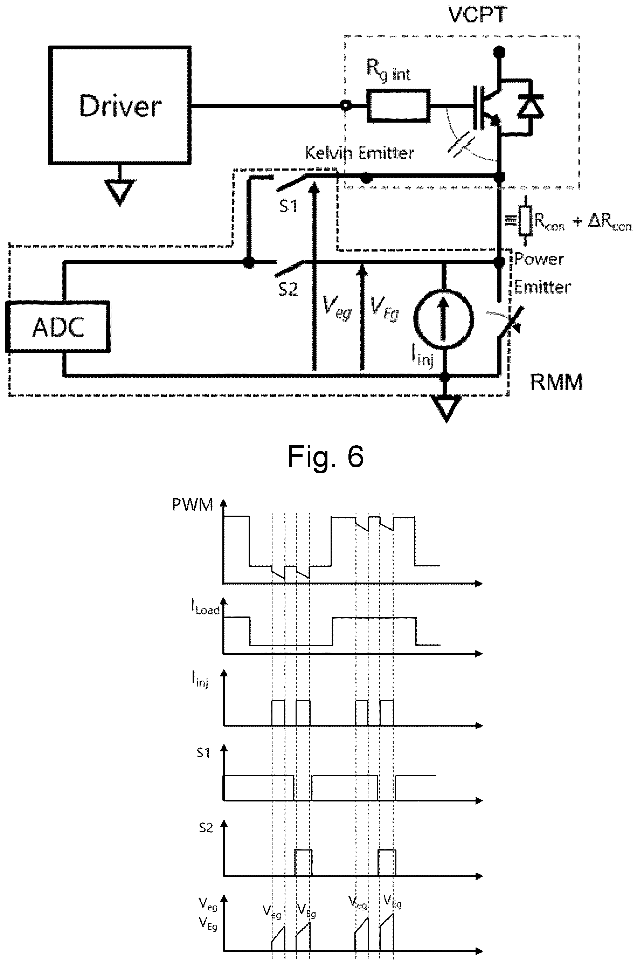

An advantage of this configuration is, as already explained, that the monitoring is independent of the transistor temperature. It can be performed on-line, i.e. even when the temperature of the die is not stable or not equal to the baseplate temperature. An alternative circuit of measurement is shown in figure 6, where the current injection is directly connected to the power emitter and the ADC can measure $V_{eg}$ and $V_{Eg}$ through two switches. Advantageously, the current source path is not changed during the measurement and will be more immune of disturbances.

In addition, this situation also allows measuring load current in ON-state of the power transistor. More specifically, according to the disclosure, using the measurement of the wire bonds degradation in OFF-state allows determining the load current in ON-state. By alternately measuring the equivalent resistance of the wire bond in OFF-sate, and the voltage response in ON-state, one can have information of the load current. Figure 6 illustrates the sequence of measurement to alternately measure the wire bonds degradation and the load current.

For achieving this result, the following example method can be implemented:

- Inject a DC current through the Kelvin emitter in OFF-state, and measure a first voltage response, V1;
- Inject a DC current through the power emitter in OFF-state, and measure a second voltage response, V2;
- Compute a degradation estimation as the subtraction of the two voltage responses, V2-V1;
- Inject a DC current through the Kelvin emitter in ON-state, measure a third voltage response, V3;
- Inject a DC current through the power emitter in ON-state, measure a fourth voltage response, V4;
- Compute the load current as the ratio between the difference of the fourth and third voltage responses and the degradation estimation, (V4-V3)/(V2-V1);

This exemplary method provides several advantages: the monitoring of the degradation and the measure of the load current can be performed in on-line measurement, meaning in a continuous way and the measurement is not intrusive and cannot disturb the operation of the device itself. One can also note that the voltage V1 can be used to estimate the actual temperature Tj with state-of-the-art method. Hence, both the degradation (the resistance), Tj and the load currents are measured using the same measurement sequence, which is convenient when the circuit arrangement is "connected" to several different power transistors, thru the equivalent of switches (for example digitally actionable circuits).

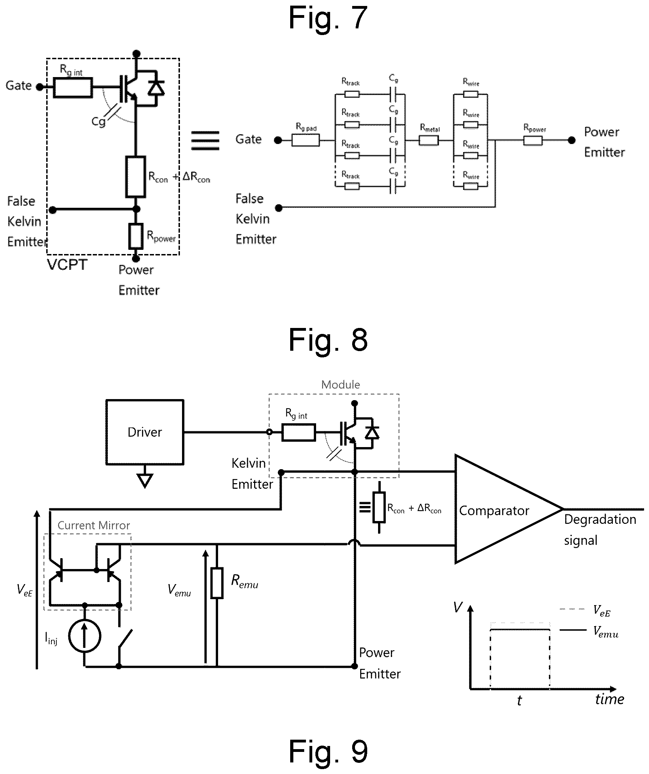

In another situation, the load current can be measured in the case of a false kelvin emitter. A false kelvin emitter can be present in several power transistors and include the wires, as shown in figure 8. A resistance of connection $R_{power}$ remains between the false kelvin emitter and the Power emitter and can be used as a shunt resistance. Assuming $R_{power}$ is stable with the temperature and during the lifetime of the VCPT, $R_{power}$ can be measuring between the false kelvin emitter and the power emitter in OFF-state and the load current can be measured in ON-state.

For achieving this result, the following example method can be implemented:

- Inject a DC current through the false Kelvin emitter in OFF-state, measure a first voltage response, V1';
- Inject a DC current through the power emitter in OFF-state, measure a second voltage response, V2';
- Compute the shunt resistance, $R_{power}$, parameter as the subtraction of the two voltage responses, V2'-V1';
- Inject a DC current through the false Kelvin emitter in ON-state, measure a third voltage response, V3';
- Inject a DC current through the power emitter in ON-state, measure a fourth voltage response, V4';
- Compute the load current as the ratio between the difference of the fourth and third voltage responses and the degradation estimation, (V4'-V3')/(V2'-V1');

In addition, the load current measurement can be done with false kelvin emitter.

Additionally, the following step can be added:

- Determine the degradation $\Delta R_{con}$ using the formula $(V3'-V1')/I_{load}$ and removing the initial value $R_{con}$ at t=0 where $\Delta R_{con} = 0$.

Indeed, according to the disclosure, the voltages V1' and V3' can be expressed as:

$$V1' = R_{g\ int} \times I_{inj} + (R_{con} + \Delta R_{con}) \times I_{inj} + \frac{t \times I_{inj}}{C_g}$$

$$V3' = R_{g\ int} \times I_{inj} + (R_{con} + \Delta R_{con}) \times (I_{inj} + I_{load}) + \frac{t \times I_{inj}}{C_g}$$

$\Delta R_{con}$ being the degradation-dependent contribution to the total gate loop resistance. $R_{g\text{-total}}$ being the total gate loop resistance. The degradation can thus be estimated in addition to the current. Finally, the following step can be added:

- Determine Tj using $V1' - \Delta R_{con} \times I_{inj}$.

Thus Tj can be estimated in addition to the degradation and to the current and the measured Tj is independent of the degradation.

### 5.4. Low-cost degradation measurement

In some situations, it may be desirable to measure the wire bond degradation, even for cost sensitive electronic circuit designs. In these situations, the use of an ADC is not necessarily possible. In order to still be able to provide a solution for the aforementioned problem in such cases, the inventors determined an alternative solution which is based on a logical (analogic) comparator with a threshold resistance $R_{emu}$. Figure 9 illustrates such a circuit arrangement.

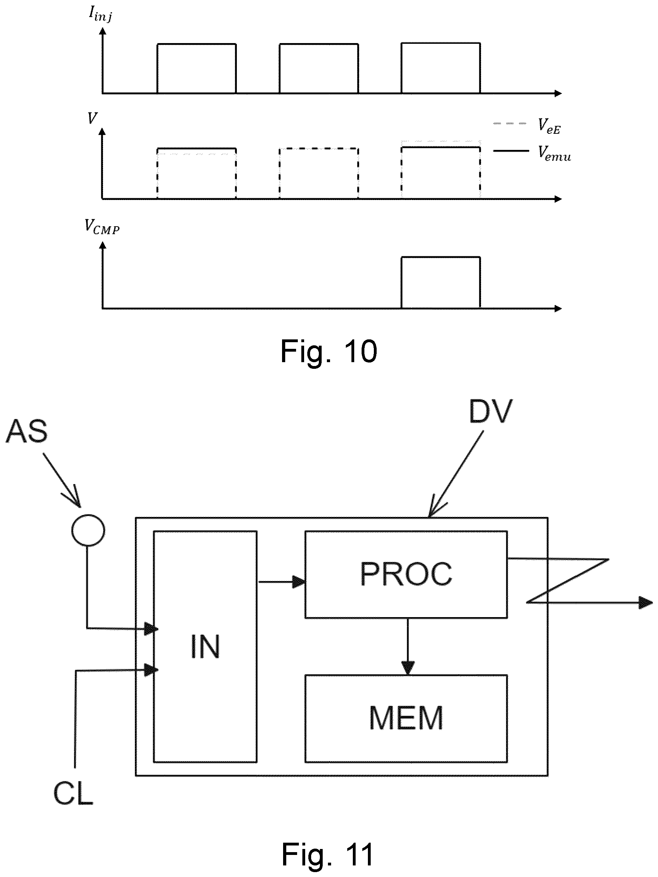

As illustrated, the circuit arrangement can be designed by using a pulse current copied in two paths. One is injected between the kelvin emitter and the power emitter and the second is injected trough an emulator constituted of an equivalent threshold resistance corresponding of a resistance of degraded wire-bond. The voltages ($V_{eE}$ and $V_{emu}$) are then compared with a comparator allowing to monitor the degradation of the wire-bonds of the transistor. As described in figure 9, the voltage across the Kelvin emitter and the power emitter is compared to the voltage of the emulator circuit. If $V_{eE}$ is higher than the $V_{emu}$, the wire-bond of the transistor are more degraded than the degradation threshold, and the result of the comparator is 1. Figure 10 shows the response of the comparator for 3 different states of degradation of the transistor. In the first pulse, $V_{eE}$ lower than $V_{emu}$ meaning that the transistor is below the threshold degradation. In the second pulse $V_{eE}$ equal $V_{emu}$ meaning that the transistor is at the maximum degradation before the threshold. In the third pulse $V_{eE}$ is higher than $V_{emu}$ indicating that the transistor is more degraded than the degradation threshold.

Advantageously, the degradation of wire bonds can be done on-line without calibration procedure during the operation of the system. It can also be done without the need of an ADC which can reduce the price of the degradation monitoring device. Moreover, this technic is also independent of the temperature of the transistor. Hence, the monitoring can be performed in on-line diagnostic and is independent of the transistor temperature, the measurement is not intrusive and cannot disturb the operation of the device, the short pulse current cannot modify the normal operation of the transistor.

### 5.5. Other features and advantages

As shown in figure 11, the device DV for monitoring the degradation of voltage-controlled power transistor, as presented above, can comprises an antenna system AS, for example coupled through an interface IN to a processing circuit including a processor PROC and a memory MEM. Alternatively, or in complement, or as a variant, of the antenna system AS, necessary data (resistance measurements) can also be received thru a communication link CL allowing the device to monitor the degradation of voltage-controlled power transistor. The memory stores at least instructions of a computer program according to the present disclosure. By carrying out this type of processing, and in particular by implementing the data structures (initial resistance measurements, cycles, subsequent resistance measurements) according to the method of the disclosure, the device's processor has proven to be able to monitor the degradation of voltage-controlled power transistor, in an efficient and industrially applicable way.

In preferred embodiments, the computer system or device comprises one or more processors (which may belong to a same computer or to different computers) and one or more memories (magnetic hard disk, optical disk, electronic memory, or any computer readable storage medium) in which a computer program product is stored, in the form of a set of program-code instructions to be executed in order to implement all or part of the steps of the generating and/or testing method. Alternatively, or in combination thereof, the computer system can comprise one or more programmable logic circuits (FPGA, PLD, etc.), and/or one or more specialized integrated circuits (ASIC), etc., adapted for implementing all or part of said steps of the generating and/or testing method and/or part of the modules described above. In other words, the computer system comprises a set of means configured by software (specific computer program product) and/or by hardware (processor, FPGA, PLD, ASIC, etc.) to implement the steps of the generating and/or testing method.

**Claims**

1. An electronic circuit arrangement comprising at least one voltage-controlled power transistor (VCPT, MOSFET, IGBT), the electronic circuit arrangement comprising a degradation measurement module (DMM) for monitoring the degradation of the at least one voltage-controlled power transistor (VCPT), the degradation measurement module comprising a current injection module (CIM) which is connected to the emitter of the at least one voltage-controlled power transistor (VCPT), and a degradation measurement module (DMM), the degradation measurement module being able to measure a first voltage ($V_{eg}$) following a current injection (Iinj) at the emitter of the at least one voltage-controlled power transistor (VCPT), the current injection module (CIM) and the degradation measurement module (DMM) being connected to the same ground.

2. The electronic circuit arrangement according to claim 1, wherein the electronic circuit arrangement further comprises at least one switch (S0, ...), the switch having an open state and a closed state, the closed state being switchable to the open state for allowing the degradation measurement module (DMM) to measure the voltage (Veg) following the current injection (Iinj) at the current injection module (CIM).

3. The electronic circuit arrangement according to claim 1 and 2, wherein the electronic circuit arrangement is linked to a driver (DRIVER) of the at least one voltage-controlled power transistor (VCPT), the driver being connected to the gate of the at least one voltage-controlled power transistor (VCPT) and the ground of the driver being the same that the one of the current injection module (CIM) and of the degradation measurement module (DMM).

4. The electronic circuit arrangement according to any of claim 1 to 3, wherein the at least one voltage-controlled power transistor (VCPT) comprises a Kelvin Emitter and wherein the electronic circuit arrangement comprises at least two additional switches (S1, S2) allowing the degradation measurement module (DMM) to measure the first voltage ($V_{eg}$), and allowing the degradation measurement module (DMM) to measure a second voltage ($V_{Eg}$) following a current injection (Iinj) at the Kelvin Emitter.

5. The electronic circuit arrangement according to any of claim 1 to 4, wherein the degradation measurement module (DMM) comprises an analog-to-digital converter (ADC).

6. The electronic circuit arrangement according to any of claim 1 to 4, wherein the degradation measurement module (DMM) comprises:

    - a current mirror component (CMC) to copy the current injection (Iinj) of the current injection module (CIM) in two distinct current flow,
    - the first current flow being injected into the Kelvin Emitter of the at least one voltage-controlled power transistor (VCPT) for measuring a first voltage ($V_{eE}$),
    - the second current flow being injected into a subcircuit comprising a threshold resistance ($R_{emu}$) for measuring a threshold voltage ($V_{emu}$),
    - a comparator, the inputs of which receiving the first voltage ($V_{eE}$) and the threshold voltage ($V_{emu}$), the comparator delivering a degradation signal.

7. A method for monitoring the degradation of at least one voltage-controlled power transistor (VCPT, MOSFET, IGBT), the method using an electronic circuit arrangement according to any of claims 1 to 6, the method at least one iteration of:

    - checking whether at least one predetermined condition for degradation monitoring of the at least one voltage-controlled power transistor (VCPT) is met,
    - when it is determined that the at least one condition is met:

- injecting a direct current DC, using the CIM, at the power emitter of the at least one voltage-controlled power transistor (VCPT),

- measuring, using the RMM, at least one voltage response ($V_{eg}$, $V_{EG}$).

8. The method according to claim 7, wherein the at least on predetermined condition for degradation monitoring of the at least one belongs to the group comprising: a temperature the at least one voltage-controlled power transistor (VCPT), a specific state of the at least one voltage-controlled power transistor (VCPT).

9. The method according to claim 7 or claim 8 wherein the method further comprises, with the at least one voltage response ($V_{eg}$, $V_{Eg}$), obtaining at least one internal resistance ($R_{g\text{-}total}$) of the at least one voltage-controlled power transistor (VCPT).

10. The method according to claim 9 wherein the method further comprises determining that the at least one internal resistance ($R_{g\text{-}total}$) of the at least one voltage-controlled power transistor (VCPT) exceeds a predetermined value and transmitting an alarm signal to a monitoring device.

11. A computer program comprising instructions causing the implementation of the method according to anyone of the preceding claims when such instructions are run by a processor.

12. A device for monitoring the degradation of at least one voltage-controlled power transistor (VCPT) implanted on a power electronic circuit, the system comprising at least one electronic circuit arrangement according to any of claim 1 to 6 and at least one driver for driving the current flow in said of at least one voltage-controlled power transistor (VCPT), the system further comprising a monitoring module for receiving data representing the degradation of at least one voltage-controlled power transistor (VCPT) from the at least one electronic circuit arrangement.

13. An electronic device comprising a device according to claim 12.

# Fig. 1

# Fig. 2

# Fig. 3

Fig. 4

Fig. 5

VCPT

Driver

$R_{g\ int}$

Kelvin Emitter

S1

S2

$V_{eg}$ | $V_{Eg}$

$I_{inj}$

ADC

$R_{con} + \Delta R_{con}$

Power Emitter

RMM

# Fig. 6

PWM

$I_{Load}$

$I_{inj}$

S1

S2

$V_{eg}$
$V_{Eg}$

$V_{eg}$  $V_{Eg}$    $V_{eg}$  $V_{Eg}$

EP 4 600 670 A1

# Fig. 7

# Fig. 8

# Fig. 9

$I_{inj}$

$V$

$V_{eE}$

$V_{emu}$

$V_{CMP}$

## Fig. 10

AS

DV

IN

PROC

MEM

CL

## Fig. 11

Europäisches
Patentamt

European
Patent Office

Office européen
des brevets

## EUROPEAN SEARCH REPORT

**Application Number**

EP 24 30 5231

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 249 927 A1 (MITSUBISHI ELECTRIC CORP [JP] ET AL.) 27 September 2023 (2023-09-27) * figures 1-14 * * paragraph [0036] - paragraph [0068] * ----- | 1-5,7-13 | INV. G01R31/26 G01R31/28 |
| X | US 2021/318375 A1 (LEE JUNHO [KR] ET AL) 14 October 2021 (2021-10-14) * figures 1-8 * * paragraph [0019] - paragraph [0047] * ----- | 1,4,7, 9-11 | |
| X | EP 3 255 443 A1 (ROLLS ROYCE PLC [GB]) 13 December 2017 (2017-12-13) * paragraph [0006] - paragraph [0062]; figures 1-19 * ----- | 1,6,7,11 | |

| | |
|---|---|
| **TECHNICAL FIELDS SEARCHED (IPC)** | |
| G01R | |

The present search report has been drawn up for all claims

| Place of search | Date of completion of the search | Examiner |
|---|---|---|
| Munich | 24 June 2024 | Sedlmaier, Stefan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 30 5231

This annex lists the patent family members relating to the patent documents cited in the above-mentioned European search report.
The members are as contained in the European Patent Office EDP file on
The European Patent Office is in no way liable for these particulars which are merely given for the purpose of information.

24-06-2024

| Patent document cited in search report | | Publication date | Patent family member(s) | | Publication date |
|---|---|---|---|---|---|
| EP 4249927 | A1 | 27-09-2023 | EP | 4249927 A1 | 27-09-2023 |
| | | | WO | 2023181444 A1 | 28-09-2023 |
| US 2021318375 | A1 | 14-10-2021 | NONE | | |
| EP 3255443 | A1 | 13-12-2017 | EP | 3255443 A1 | 13-12-2017 |
| | | | US | 2017350934 A1 | 07-12-2017 |

EPO FORM P0459

For more details about this annex : see Official Journal of the European Patent Office, No. 12/82